Europäisches Patentamt

(19) **European Patent Office**

Office européen des brevets

(11) Publication number: **0 254 804**
**A2**

(12) # EUROPEAN PATENT APPLICATION

(21) Application number: **87104833.6**

(22) Date of filing: **01.04.87**

(51) Int. Cl.³: **H 02 H 3/04**
**H 05 B 37/03**

(30) Priority: **01.08.86 US 891841**

(43) Date of publication of application:
**03.02.88 Bulletin 88/5**

(84) Designated Contracting States:
**DE FR GB SE**

(71) Applicant: **Tideland Signal Corporation**
**4310 Directors Row**
**Houston Texas 77092(US)**

(72) Inventor: **Tigwell, David Charles**
**519 Willow Wisp Circle**
**Spring, Texas 77388(US)**

(74) Representative: **Henkel, Feiler, Hänzel & Partner**
**Möhlstrasse 37**
**D-8000 München 80(DE)**

(54) **Electrical continuity sensing circuit.**

(57) An electrical sensing circuit whose onlt active components are digital logic gates for measuring the continuity of a second circuit such as a series circuit having a power supply, a lamp, and a switch. The secondary of a transformer is connected in series in the series circuit. A square wave generator is connected through an inverter and a resistor to the primary of the transformer. A second inverter is connected to the transformer primary and to a logic gate, schmitt trigger, or comparator whereby a low voltage level at the comparator is an indication of a continuous series circuit and low to high voltage level transitions are an indication of a discontinuity.

Fig. 1

EP 0 254 804 A2

-1-

## ELECTRICAL CONTINUITY SENSING CIRCUIT

### Background of the Invention

The present invention is directed to measuring the electrical continuity of an electrical circuit and in particular measuring whether a lamp in a navigational light is burned out. United States Patents Nos. 3,577,135 and 3,855,586 disclose electrical circuits for determining when a navigational light is burned out in order to allow a lamp changing circuit to position a new light in the operative position. However, since navigational lights are located in remote locations and operated by batteries, it is important that the battery power be conserved.

The present invention is directed to an electrical continuity measuring circuit using digital components and has essentially no power losses. In particular, the invention is capable of verifying the filament integrity in a lamp circuit whether the lamp switch is opened or closed, the circuit is not sensitive to the polarity of the lamp circuit, the sensing circuit works with AC lamps, and the sensing circuit is magnetically isolated from the lamp circuit.

## Summary

The present invention is directed to an electrical sensing circuit for measuring the continuity of a second circuit and includes a transformer having a primary and a secondary with the secondary being connected in the second circuit. A voltage source having a plurality of sharp rising edges is connected to the primary of the transformer and a logic gate, schmitt trigger, or comparator is connected to the transformer primary for measuring the voltage level from the transformer primary whereby a low voltage level is an indication of a continuous second circuit and logic level pulses are an indication of a discontinuity in the second circuit.

A still further object of the present invention is wherein a square wave generator is provided for supplying a plurality of sharp transitions and is connected through a first inverting buffer and a resistor to the primary of the transformer. A diode is connected across the primary of the transformer and a second inverting buffer is connected between the transformer and the logic gate, schmitt trigger, or comparator.

Still a further object of the present invention is the provision of an electrical sensing circuit for measuring the continuity of a series circuit having a power supply, a lamp and a switching means. An RC series circuit is connected in parallel with the switching means wehreby the sensing circuit may measure the continuity of the lamp whether the switching means is opened or closed.

Still further object of the present invention is the provision of an electrical sensing circuit for measuring the continuity of a series circuit having a power supply, a lamp and a switching means. A transformer having a primary and a secondary with the primary having a greater number of primary coils than the number of secondary coils, is provided with the secondary being connected in series with the series circuit.

One end of the primary coil is connected to ground and a diode is connected across the primary of the transformer. A square wave generator is connected to the other end of the primary coil through an inverter and a resistor. A logic gate, schmitt trigger or comparator is connected to the other end of the primary coil for measuring the voltage level across the transformer primary.

Other and further objects, features and advantages will be apparent from the following description of a presently preferred embodiment of the invention, given for the purpose of disclosure and taken in conjunction with the accompanying drawings.

### Brief Description of the Drawings

Fig. 1 is an electrical schematic diagram of the invention connected to a lamp circuit in which the lamp filament is good,

Fig. 2 is an electrical schematic diagram similar to that in Fig. 1 in which the lamp filament is broken, and

Figs. 3A, 3B, 3C, 3D and 3E are graphs showing the wave forms at various points in the electrical circuits of Figs. 1 and 2.

### Description of the Preferred Emboidment

While the present invention is suitable for measuring the electrical continuity of various electrical circuits and components without affecting their operation, such as blasting caps and the continuity of any resistive component, the present invention will be described, for purposes of illustration only, as measuring the resistance of a lamp in a navigational light.

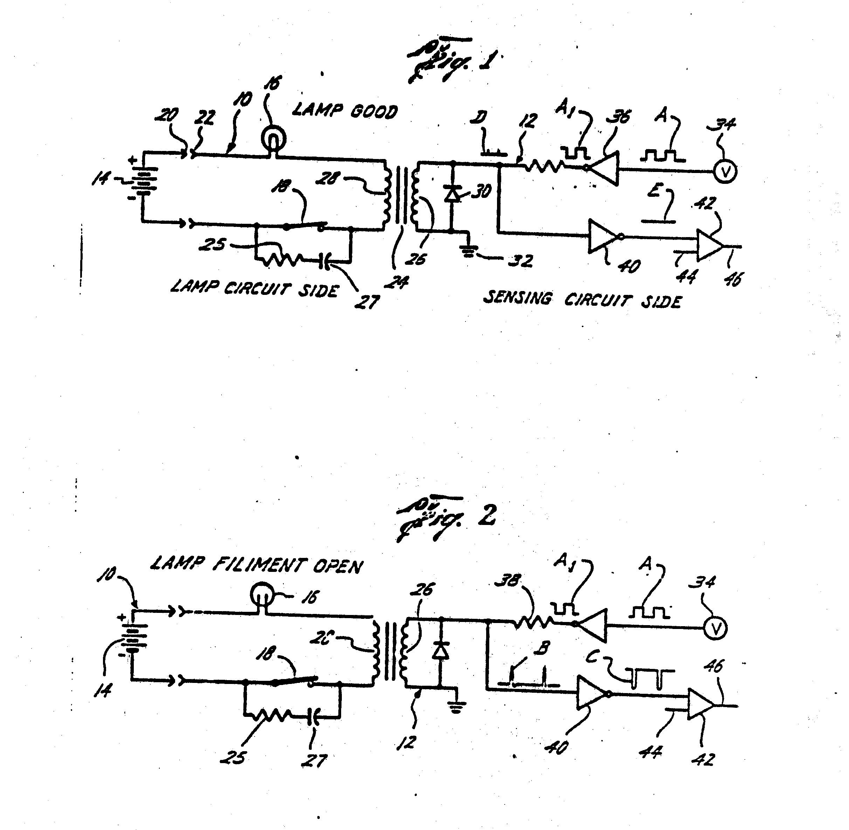

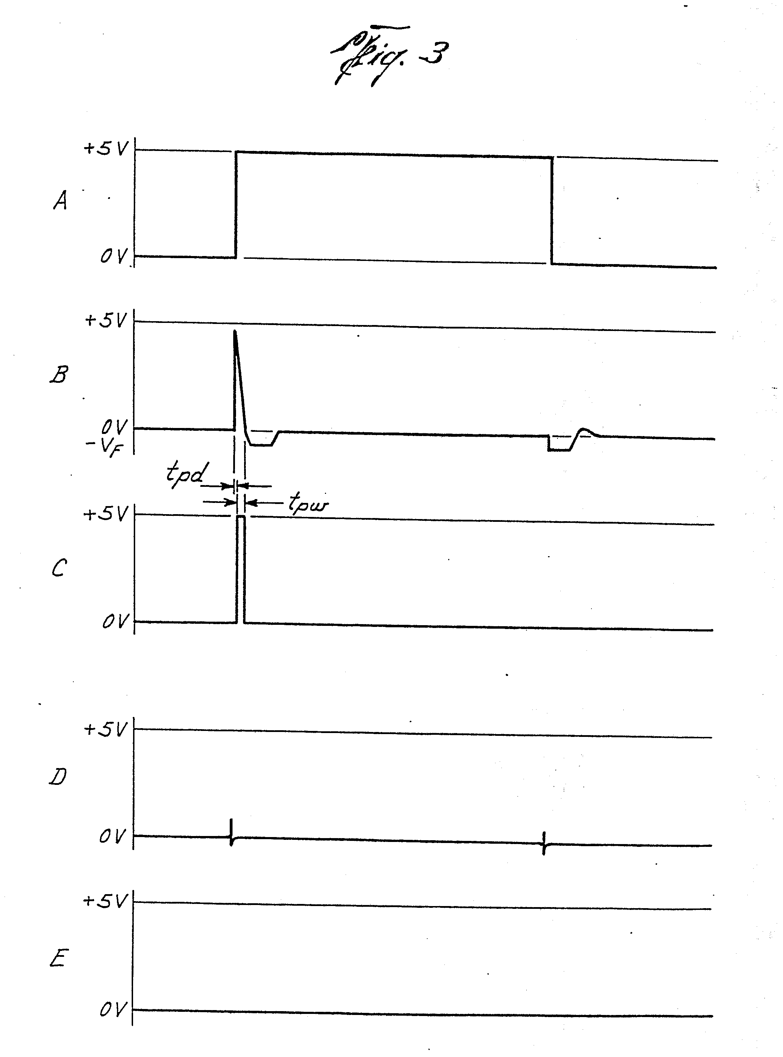

Referring now to the drawings, and particularly to Figs 1 and 2, the reference numeral 10 generally indicates the lamp side circuit and the numeral 12 generally indicates the sensing circuit of the present invention.

The lamp circuit 10 basically includes a power source 14 such as a battery, a lamp 16, and switching means 18. The above basic description of a lamp circuit is shown in Patent No. 3,855,586 which is incorporated herein by reference. The circuit 10 also includes moving contacts 20 for coacting with fixed contacts 22 whereby when the lamp 16 burns out a new lamp may be rotated into the operative position. The purpose of the sensing circuit 12 is to determine when the lamp 16 is burned out and to provide a signal to a lamp changing circuit which replaces the old lamp with the new lamp.

The sensing circuit 12 electronically detects the integrity of the lamp 16 using digital logic gates with essentially no power losses. An RC circuit comprising resistor 25 and capacitor 27 is in parallel with the switch 18. The circuit 12 is capable of verifying the continuity of the lamp 12 with the switch 18 open or closed, and it is not sensitive to the polarity of the lamp circuit 10, and in fact may even be used with AC lamp circuits.

The sensing circuit 12 includes a transformer 24 having a primary coil 26 and a secondary coil 28 and may be of any suitable type such as a ferrite transformer with a turns ratio of 3:1 of the primary coil 26 to the secondary coil 28. The secondary coil 28 is placed in series with the lamp 16. The impedance of the lamp circuit 10 is reflected to the primary coil 26 of the transformer 24 as a square of the turns ratio between the primary coil 26 and the secondary coil 28. When the lamp 16 is good, as in Fig. 1, the primary 26 appears as a low impedance, but when the lamp filament is opened as in Fig. 2, the primary 26 appears as an inductance.

A diode 30 is provided across the primary coil 26 of the transformer 24, one side of which is connected to ground 32. The diode clamps the reverse voltage through the primary transformer coil 26.

A voltage source 34 having a plurality of sharp rising edges is connected to the primary 26 of the transformer 24 through an inverter 36 and a resistor 38. Thus, a sharp rising edge wave form such as a square wave A is applied to the input of the inverter 36 as best seen in Fig. 3A. The wave form is inverted at position A1. A second inverter 40 is connected to one side of the primary coil 26 therefore essentially placing the impedance of the resistor 38 and the impedance in the coil 26 in series. That is, the output of inverter 40 may be used to actuate a lamp changing circuit as shown in Patent No. 3,855,586.

Typical component values are as follows: The resistance of the filament of the lamp 16 varies from 1.0 to 50 ohms, typically, the resistance of resistor 25 may be 2.7 ohms, the capacitance of the capacitor 27 may be 0.1 microfarads, and the resistance of the resistor 38 is 10 kilohms.

Referring now to Fig. 1 in which the lamp 16 is good, the secondary side impedance is essentially the lamp filament resistance which is approximately 1.0 to 50 ohms. This impedance is reflected to the primary coil 26 multiplied by the square of the turns ratio, in this case nine, but this impedance is considerably smaller than the impedance of the resistor 38. Therefore, the wave form D, as shown in Fig. 3D is applied to the input of the inverter 40 which provides only very small voltage spikes which are not sufficient to actuate the inverter 40 and therefore the output wave form E as best seen in Fig. 3E is essentially zero.

On the other hand, as best seen in Fig. 2, with the lamp filament open, the impedance in the secondary side circuit is substantially a pure inductance. As the square waves contain high frequency components (above three megahertz) the inductive reactance (>50K ) through the primary coil 26 is much greater than the resistance of the resistor 38 thereby providing a wave form B as best seen in Fig. 3B which when inverted by the inverter 40 produces a wave form C, as best seen in Fig. 3C. Thus, low going voltage levels at the inverter 40 is an indication of discontinuity in the circuit 10, while a constant high voltage level is an indication of continuity in the circuit 10.

The sensing circuit 10 is magnetically isolated from the lamp circuit 10 and does not interfere with its operation. And while the sensing circuit 12 may measure the continuity of the circuit 10 without the RC circuit 25-27, when the switch 18 is closed, the addition of the RC circuit allows the measurement to be made regardless of whether the switch 18 is opened or closed.

The present invention, therefore, is well adapted to carry out the objects and attain the ends and advantages mentioned as well as others inherent therein. While a presently preferred embodiment of the invention has been given for the purpose of disclosure, numerous changes in the detail of construction and arrangement of parts may be made without departing from the spirit of the invention and the scope of the appended claims.

What is claimed is:

Claims

-7-

1.  An electrical sensing circuit for measuring the continuity of a second circuit comprising,

a transformer having a primary and a secondary, said secondary being connected in the second circuit,

a voltage source having a plurality of sharp transitions connected to the primary of the transformer, and

a logic gate, schmitt trigger, or comparator connected to the transformer primary for measuring the voltage level across the transformer primary whereby a constant voltage level is an indication of a continuous second circuit and a toggeling voltage level is an indication of a discontinuity.

2.  An electrical sensing circuit for measuring the continuity of a second circuit comprising,

a transformer having a primary and a secondary, said secondary being connected in the second circuit,

a square wave generator connected to the primary of the transformer,

a resistor connected between the square wave generator and the transformer,

a logic gate, schmitt trigger, or comparator connected to the transformer primary for measuring the voltage level across the transformer primary whereby a constant level is an indication of a continuous second circuit and a high voltage level is an indication of a discontinuity.

3.  The apparatus of claim 2 including, a first inverter connected between the generator and the resistor, and

a second inverter connected between the transformer and the logic gate, schmitt trigger, or comparator, and

a diode connected across the primary of the transformer.

4. An electrical sensing circuit for measuring the continuity of a series circuit having a power supply, a lamp and switching means, comprising,

a transformer having a primary and a secondary, said secondary being connected in the series circuit,

a voltage source having a plurality of sharp rising edges connected to the primary of the transformer,

a resistor connected between the voltage source and the transformer, and

a logic gate, schmitt trigger, or comparator connected to the transformer for measuring the voltage level across the transformer primary.

5. The apparatus of claim 4 including,

an RC series circuit connected in parallel with the switching means.

6. The apparatus of claim 4 including,

a first inverter connected between the generator voltage source and the resistor,

a second inverter connected between the transformer and the logic gate, schmitt trigger, or comparator, and

a diode connected across the primary of the transformer.

7. The apparatus of claim 4 including,

the primary of the transformer having a greater number of turns than the secondary of the transformer.

8. An electrical sensing circuit for measuring the continuity of a series circuit having a power supply, a lamp and switching means comprising,

a transformer having a primary and a secondary, said primary having a greater number of primary coils than the number of secondary coils, said secondary being connected in series in the series circuit, one end of the primary coil being connected to ground,

a square wave generator connected to the other end of the primary coil,

an inverter connected between the generator and the transformer,

a resistor connected between the inverter and the transformer,

a diode connected across the primary of the transformer,

a second inverter connected to the other end of the primary coil, and

a logic gate, schmitt trigger, or comparator connected to the second inverter for measuring the voltage level across the transformer primary.

9. The apparatus of claim 8 including,

an RC series circuit connected in parallel with the switching means.

0254804

**Fig. 1**

LAMP GOOD

20 22 10 16    D  12  $A_1$  38  A  34  V

14

LAMP CIRCUIT SIDE

28  18  25  27  24  26  30  32  E  40  42  44  46

SENSING CIRCUIT SIDE

**Fig. 2**

LAMP FILIMENT OPEN

10  16  26  38  $A_1$  A  34  V

14  18  2C  25  27  12  B  C  40  44  42  46

0254804

_Fig. 3_